# EUROPEAN PATENT SPECIFICATION

(11) **EP 2 515 324 B1**
(45) Date of publication and mention of the grant of the patent: **30.03.2022**
(21) Application number: 10837547.8
(22) Date of filing: 13.12.2010
(51) Int. Cl.: H01L 21/027, H01L 21/67, G03F 7/42

(54) **SUBSTRATE TREATMENT DEVICE**
SUBSTRATBEHANDLUNGSVORRICHTUNG
DISPOSITIF DE TRAITEMENT DE SUBSTRAT

(30) Priority: 18.12.2009 JP 2009287797; 19.11.2010 JP 2010259231
(43) Date of publication of application: 24.10.2012
(73) Proprietor: J.E.T. Co., Ltd., Okayama 719-0302 (JP)
(72) Inventor: FUNABASHI Michimasa, Tachikawa-shi Tokyo 190-0012 (JP); OTOKUNI Kenji, Tachikawa-shi Tokyo 190-0012 (JP); EDO Hiroki, Tachikawa-shi Tokyo 190-0012 (JP); SUZUKI Hideaki, Tachikawa-shi Tokyo 190-0012 (JP)
(74) Representative: Beetz & Partner mbB
(86) International application number: PCT/JP2010/072342
(87) International publication number: WO 2011/074521

(56) References cited:
- DE-A1-102008 035 802
- JP-A- 2 004 269
- JP-A- 2004 273 838
- JP-A- 2008 153 521
- US-A- 5 113 929
- US-A1- 2002 096 196
- US-A1- 2003 172 955
- US-B1- 6 463 941

## Description

### Technical Field

The present invention relates to a substrate processing device that processes a substrate for a semiconductor, etc., to eliminate deposits like a thin film formed on the surface of the substrate.

### Background Art

Various thin films are provided to form an electronic circuit on a substrate in semiconductor manufacturing processes, but such thin films like a resist must be eliminated when becoming unnecessary.

Example devices which eliminate such thin films and which are conventionally known are a batch-type device that soaks a plurality of substrates in a bath filled with a process liquid acting on the thin-film forming substances to process the substrates, and a single-wafer-type device that supplies a process liquid to the surface of the substrate one by one to process the substrate.

According to the batch-type device, as explained above, foreign materials like resists are eliminated while the substrates are soaked in the bath filled with the process liquid, and thus the foreign materials eliminated from the substrates remain in the process liquid. Hence, there is a system which causes the process liquid to overflow from the top of the bath, circulates the overflowed process liquid to filtrate the process liquid during the circulation, and returns the filtrated liquid to the bath. However, since the process liquid overflowed from the top of the bath is circulated, not all amount of the process liquid is circulated. Accordingly, even if the process liquid is filtrated through the circulation, it is difficult to completely remove the foreign materials in the process liquid, and the foreign materials like the above-explained resists may remain in the process liquid.

Moreover, when the specific gravity of the foreign material eliminated from the substrate is heavier than that of the process liquid, even if the process liquid is circulated, the foreign materials may directly remain in the bath.

Accordingly, even if the process liquid is filtrated as explained above, in the case of the batch-type process, the foreign materials in the bath may adhere again.

Moreover, in the case of the batch-type process, a plurality of bathes are provided, respective bathes are filled with different process liquids, and the substrates are successively soaked in respective bathes. Since it is necessary to provide the plurality of bathes and a carrier device that carries the substrates between the bathes, the facility becomes large in size.

In order to address such a technical issue of the bath-type device, in recent days, a single-wafer-type process device is getting attention. According to the single-wafer-type process device, the substrate is not soaked in a bath, but the process liquid is supplied to the substrate one by one, and the used process liquid is drained every time the process liquid is used. Hence, according to the single-wafer-type process device, foreign materials do not adhere again after the process. Moreover, it is possible to eliminate different kinds of thin films by changing the process liquid to be supplied without carrying the substrate.

For example, Patent Literature 1 discloses such a device that is conventionally known.

This device supplies, while rotating a substrate held horizontally with a processed surface thereof being directed to the above, the process liquid from above the center of the surface. The process liquid supplied to the center of the substrate peels thin films while flowing over the substrate toward the outer circumference thereof, and the peeled thin films are drained together with the process liquid.

A similar device is described in US 2002/096196 A1.

### Citation List

### Patent Literature

Patent Literature 1: JP 2005-051101 A

### Summary of Invention

### Technical Problem

According to the above-explained conventional single-wafer-type process device, since the process liquid is supplied from above the substrate with the processed surface thereof being directed upwardly, supply means is necessary at the supply side. Hence, the supply means of the process liquid interrupts to cover the upper space of the substrate, and the device disclosed in Patent Literature 1 leaves the upper space of the substrate opened. When the upper space of the substrate is kept opened, the supplied process liquid or the vapors thereof spill out to the exterior of a housing.

However, the process liquid varies depending on the kind of the thin films to be eliminated, but most process liquids are strongly acidic or alkaline. Hence, if the process liquid spills out to the exterior of the housing, the process liquids adhere to various devices and wirings outside the housing and may damage such devices and wirings.

Accordingly, in order to prevent the process liquid from spilling out to the exterior of the housing, conventionally, the processing-surface side of the substrate directed upwardly may be covered by the housing also including the supply means over the substrate.

In this case, however, since the processing surface of the substrate faces the ceiling surface of the housing, the process liquid supplied to the processing surface bounces back from the processing surface, and the bounced process liquid adheres to the ceiling surface of the housing.

Moreover, when the process liquid is vaporized, the vapors adhere to the ceiling surface of the housing.

When the process liquid or the vapors adhered to the ceiling surface as explained above is left as it is, such process liquid and vapors fall down and contaminate the already-processed substrate or the substrate newly set, and thus such adhering process liquid should be completely eliminated. However, in order to eliminate the process liquid and the vapors from the ceiling surface, procedures of, for example, cleaning by pure water and letting the pure water completely dried are necessary. Since the procedures of cleaning and drying are necessary, it takes a time for cleaning and drying by what corresponds to those procedures.

The document DE 10 2008 035 802 A1 discloses a substrate processing device wherein the e processing surface of the substrate faces the ceiling surface of the housing.

It is an object of the present invention to provide a single-wafer-type substrate processing device which prevents a process liquid and vapors thereof from spilling out to the exterior when directly supplying the process liquid to the surface of a substrate to process the substrate, and which prevents the process liquid and the vapors thereof, etc., from adhering to a ceiling surface of a housing.

### Solution to Problem

A substrate processing device according to a first aspect of the present invention includes: a housing; holding means that holds, in the housing, a substrate subjected to an eliminating process of adhering materials on a processing surface of the substrate with the processing surface being directed to a bottom of the housing; supply means that supplies a process liquid to the processing surface of the substrate held by the holding means; an inlet for taking a gaseous body in the housing; and an outlet for evacuating, from the housing, vapors of the process liquid in the housing together with the gaseous body taken in from the inlet.

According to a second aspect of the present invention, the housing is provided with a guide member that guides the vapors of the process liquid in the housing to the outlet.

According to a third aspect of the present invention, the guide member is configured to have a part facing a periphery of the substrate held by the holding means, and to maintain a clearance between the part and the periphery facing with each other.

According to a fourth aspect of the present invention, the substrate processing device further includes an inlet/outlet for putting in and out the substrate to be held by the holding means to the housing, in which a part of a structure configuring the inlet/outlet is configured to face a periphery of the substrate held by the holding means, and to maintain a clearance between the part and the periphery facing with each other, and the clearance serves as the inlet of the gaseous body.

According to a fifth aspect of the present invention, the substrate processing device further includes heating means opposite to the supply means across the substrate to heat a rear face of the substrate opposite to the processing surface.

According to a sixth aspect of the present invention, the heating means utilizes infrared rays, and an infrared ray inlet is provided in a surface of the housing between the heating means utilizing the infrared rays and the substrate facing with each other.

In addition, the infrared ray inlet may be an opening or covered with an infrared-transparent material.

According to a seventh aspect of the present invention, the holding means has a rotating function for rotating the substrate held by the holding means.

According to an eighth aspect of the present invention, the substrate processing device further includes: supply means that supplies a process liquid to the processing surface; and cleaning liquid supply means that supplies a cleaning liquid for cleaning from a same direction as the supply means.

### Advantageous Effects of Invention

According to the first to eighth aspects of the present invention, the process liquid is supplied to the processing surface of a substrate with the processing surface being held and directed to the bottom of the housing. Hence, the process liquid does not spill out to the upper space of the substrate.

Moreover, the substrate having the processing surface being held and directed to the bottom has a shielding function against the supplied process liquid, and thus the process liquid does not directly spill out to the upper space of the substrate.

The vapors of the process liquid are taken out from the outlet together with a gaseous body taken in from the inlet, and thus the vapors do not go up and the process liquid does not spill out to the upper part of the housing, and even if the ceiling of the housing is opened, the process liquid and the vapors thereof do not leak out to the exterior of the housing.

The substrate has the shielding function against the process liquid and the vapors of the process liquid are surely taken out from the outlet. Accordingly, even if the upper space of the substrate is blocked by the ceiling surface, the process liquid and the vapors thereof do not adhere to the ceiling surface.

Since the process liquid and the vapors thereof do not adhere to the ceiling surface of the housing, it becomes unnecessary to clean the ceiling surface, and thus the process efficiency improves by what corresponds to such unnecessity.

According to the second aspect of the present invention, the vapors of the process liquid in the housing are smoothly guided to the outlet by the guiding member. Hence, it becomes possible to further prevent the vapors of the process liquid from going up to the upper space of the substrate.

According to the third aspect of the present invention, a gaseous body is taken in between the substrate and the guide member facing the surroundings of the substrate, and the vapors of the process liquid produced near the processing surface are further surely guided to the outlet by the flow of the introduced gaseous body.

According to the fourth aspect of the present invention, the opening configuring the inlet of the gaseous body also serves as the inlet/outlet of the substrate for taking in and taking out the substrate, and thus the setting work of the substrate is easy. In addition, the inlet/outlet for taking in and taking out the substrate is mostly blocked by the substrate, and a space with the substrate serves as the inlet of the gaseous body. Accordingly, although the inlet/outlet has a dimension for enabling taking-in and taking-out of the substrate, no process liquid spill out from this opening.

As explained above, the substrate serves as a cover that blocks the opening of the inlet/outlet of the substrate, it is unnecessary to provide a cover. Therefore, in comparison with a case in which a cover is necessary, the number of parts can be reduced, and the structure of the housing can be simplified. Moreover, when the cover is provided, it is necessary to clean and dry the cover, but according to the present invention, such cleaning and drying are unnecessary.

According to the fifth aspect of the present invention, the heating means is provided at the opposite side to the supply means of the process liquid across the substrate, and the rear face of the substrate is heated. Accordingly, the heating means is not contaminated by the process liquid, and the heating performance thereof does not decrease.

Since the heating performance of the heating means does not decrease, it is possible to efficiently heat the substrate. When the substrate is heated efficiently, it accelerates the chemical reaction of the process liquid supplied to the processing surface, and thus the adhering materials on the processing surface of the substrate can be eliminated efficiently.

Moreover, since the substrate is heated efficiently, excessive energy consumption is prevented, thereby accomplishing energy saving.

According to the sixth aspect of the present invention, the heating means utilizes infrared rays, and thus efficient heating is realized with the heating means and the substrate being held in a non-contact manner. Another example of the heating means in a non-contact manner is irradiation of microwaves, but microwave irradiation increases the facility costs, and thus the heating means utilizing infrared rays is advantageous in costs.

In particular, when the infrared ray inlet is opened, since there is no obstacle between the heating means and the rear face of the substrate, the substrate can be heated further efficiently.

According to the seventh aspect of the present invention, since the substrate can be rotated, when the process liquid is supplied to the processing surface, the process liquid can be uniformly provided to the whole surface. Since the process liquid can be uniformly provided to the whole processing surface, the elimination process can be performed uniformly.

Moreover, since the process liquid is supplied to the whole surface uniformly by rotating the substrate, the supply means does not need to have a function of dispersing the process liquid to the processing surface, thereby simplifying the structure of the supply means.

Furthermore, after the adhering materials are eliminated, when the rotating speed of the holding means is increased with the substrate being held, the process liquid on the processing surface is spilled out to the circumferential direction, and thus the substrate can be dried through a simple scheme.

When the substrate is heated by the heating means, if the substrate is rotated, it becomes easy to uniformly heat the whole surface of the substrate.

According to the eighth aspect of the present invention, the substrate processed by the process liquid can be cleaned by a cleaning liquid while being held by the holding means. In particular, since the substrate is cleaned while the cleaning liquid is supplied from the same direction as that of the process liquid, the cleaning liquid is spilled out to the same direction as that of the process liquid. Since the cleaning liquid is spilled out to the same direction as that of the process liquid, the internal wall of the housing where the process liquid adheres can be simultaneously cleaned with the substrate.

### Brief Description of Drawings

FIG. 1 is a schematic configuration diagram showing a first embodiment of the present invention;
FIG. 2 is a schematic configuration diagram showing a second example of a substrate processing device;
FIG. 3 is a schematic configuration diagram showing a third example of a substrate processing device; and
FIG. 4 is a schematic configuration diagram showing a fourth embodiment of the present invention.

### Description of Embodiments

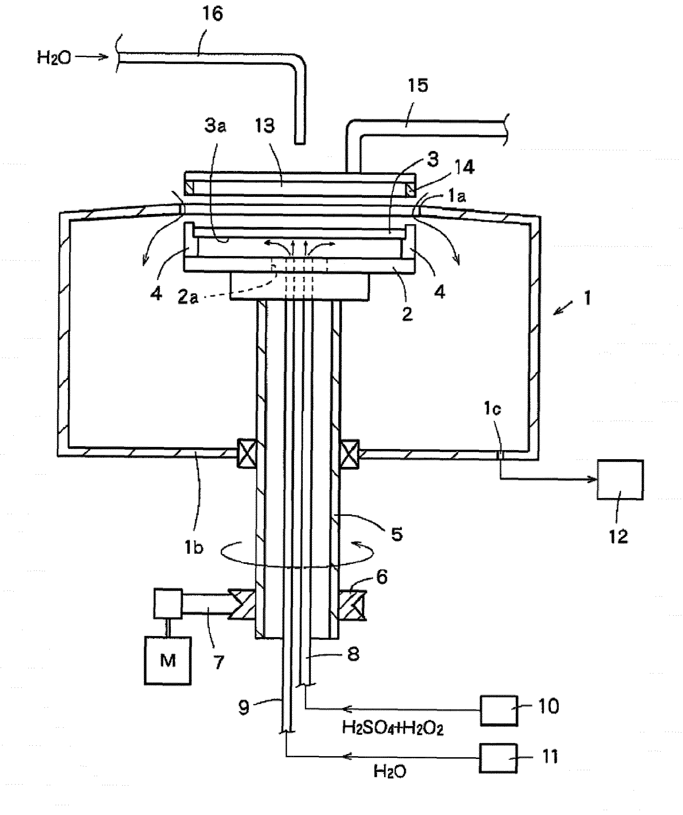

FIG. 1 is a diagram showing a structure of a substrate processing device according to a first embodiment of the present invention.

This substrate processing device is a single-wafer-type processing device that eliminates resists which are thin films from a semiconductor substrate.

According to the first embodiment, it is presumed that a process liquid used to eliminate the resists is an SPM (sulfuric-acid-hydrogen-peroxide solution). The SPM is a mixture of sulfuric acid and a hydrogen peroxide solution, and such sulfuric acid and hydrogen peroxide solution react with each other to produce Caro's acid that dissolves the resists. When the SPM is heated, the production of the Caro's acid is further accelerated.

The processing device includes a housing 1 which has a top face with a circular opening 1a. The opening 1a has a minimum requisite size for letting a substrate 3 to be processed by the processing device in and out to the housing 1. In other words, the opening 1a has a diameter slightly larger than the diameter of the substrate 3.

Moreover, a rotating table 2 is provided in the housing 1, and the rotating table 2 includes, on a surface thereof, a plurality of clampers 4 that hold the substrate 3. The plurality of clampers 4 are provided so as to maintain a space with respect to one another along the circle over the rotating table 2, clamp and hold the circular substrate 3 from the outer periphery thereof so as to be substantially parallel to the rotating table 2 while maintaining a predetermined distance therefrom.

When the clampers 4 are caused to clamp the substrate 3, a processing surface 3a where resists are formed is caused to face the rotating table 2.

That is, the plurality of clampers 4 and the rotating table 2 configure holding means of the present invention, but as explained above, the holding means has the processing surface 3a of the substrate 3 directed to a bottom 1b that is the bottom of the housing, and holds the substrate 3 near the opening 1a. Accordingly, a tiny space is formed between the periphery of the opening 1a and the outer periphery of the substrate 3 facing each other.

Moreover, a cylinder member 5 that serves as a rotational shaft of the rotating table 2 is provided at the opposite side to the clampers 4 and below the rotating table 2 in the figure. The cylinder member 5 is freely rotatably supported by a bearing provided on the bottom 1b of the housing 1. The cylinder member 5 is coupled with an electric motor M through a pulley 6 and a belt 7. Accordingly, upon driving of the electric motor M, the rotating table 2 can rotate together with the cylinder member 5. However, according to the present invention, as far as the rotating table 2 can rotate, the rotating mechanism is not limited to any particular one.

Passing through the interior of the cylinder member 5 that is the rotational shaft are a process liquid pipe 8 for supplying the SPM that is the process liquid for peeling the resists, and a water pipe 9 for supplying pure water as a cleaning liquid. Respective tips of the process liquid pipe 8 and the water pipe 9 have openings passing all the way through a through-hole 2a formed in the center of the rotating table 2 and facing the processing surface 3a of the substrate 3 clamped by the clampers 4.

Each process liquid pipe 8 and water pipe 9 is independently supported by unillustrated support means, and even if the cylinder member 5 and the rotating table 2 rotate, the process liquid pipe 8 and the water pipe 9 do not rotate.

Moreover, the openings of respective tips of the process liquid pipe 8 and the water pipe 9 supported by the support means face the center of the processing surface of the substrate 3 clamped by the clampers 4. Accordingly, the liquids released from the openings of respective tips of the process liquid pipe 8 and the water pipe 9 are supplied to the center of the processing surface 3a.

Furthermore, according to the first embodiment, no nozzle head is provided at respective tips of the process liquid pipe 8 and the water pipe 9, and the liquids are directly discharged from those pipes. However, various nozzle heads can be attached to respective tips of the process liquid pipe 8 and the water pipe 9. When a nozzle head is attached, the liquid discharged from such a nozzle head can be supplied in various forms, such as steam and line.

Moreover, the process liquid pipe 8 is connected with liquid delivery means 10 including a pump, etc., as a structural element for supplying the SPM that is the process liquid, the liquid delivery means 10 and the process liquid pipe 8 configure supply means of the process liquid according to the present invention. The liquid delivery means 10 for supplying the SPM includes mixing means that mixes sulfuric acid with hydrogen peroxide solution at the downstream side of the pump.

The water pipe 9 is connected with water delivery means 11 including a pump, etc., as a structural element for supplying pure water, and the water pipe 9 and the water delivery means 11 configure cleaning liquid supply means that supplies the cleaning liquid from the same direction as that of the supply means of the process liquid according to the present invention.

The housing 1 has an outlet 1c formed in the bottom 1b, and the outlet 1c is connected with suction means 12. Since the suction means 12 vacuums the interior of the housing 1, air is suctioned from the space between the opening 1a and the outer periphery of the substrate 3 to produce airflow, and the process liquid and vapors thereof are evacuated from the outlet 1c to the exterior of the housing 1 by this airflow.

That is, according to the first embodiment, the opening 1a is an inlet/outlet for putting in and out the substrate 3, and serves as an inlet of a gaseous body of the present invention. According to the first embodiment, the inner periphery edge of the housing 1 around the opening 1a is a part of a structure configuring the inlet/outlet of the present invention, and faces the periphery of the substrate 3.

According to the first embodiment, the SPM spilled out to the interior of the housing 1 is evacuated from the outlet 1c together with the vapors.

An infrared lamp 13 that is heating means of the present invention is provided above the opening 1a, and the infrared lamp 13 heats the rear face of the substrate 3. That is, according to the first embodiment, the opening 1a also serves as an inlet of infrared ray of the present invention. Since the infrared ray inlet is opened, there is no obstacle between the infrared lamp 13 and the rear face of the substrate 3, the substrate 3 can be heated further efficiently.

The infrared lamp 13 is supported by a support mechanism 15 so as to be capable of retracting from a range corresponding to the opening 1a. Hence, when the substrate 3 is put in and out from the opening 1a, the infrared lamp 13 does not disturb the putting in and out of the substrate. However, when the infrared lamp 13 is placed at a location sufficiently distant from the opening 1a, it is unnecessary to configure the infrared lamp 13 that is capable of retracting from the range corresponding to the opening 1a when the substrate 3 is put in and out.

Moreover, reference numeral 14 in the figure is a shield which is provided at the sides of the infrared lamp 13 and which prevents the infrared ray emitted from the infrared lamp 13 from leaking out from the sides. By providing the shield 14, it is possible to suppress a heating of a member other than the substrate 3 which does not need to be heated.

Furthermore, a water pipe 16 that supplies pure water is provided above the opening 1a, and the rear face of the substrate 3 is cleaned by pure water supplied from the water pipe 16. The water pipe 16 is retractable from the range corresponding to the opening 1a, and does not disturb the setting of the substrate 3.

Next, an explanation will be given of processes of eliminating resists on the processing surface 3a using the SPM that is the process liquid.

First, the infrared lamp 13 and the water pipe 16 are retracted from the upper space of the opening 1a of the housing 1, and the substrate 3 is set on the rotating table 2 through the opening 1a with the processing surface 3a being caused to face the rotating table 2. When the substrate 3 is set, the motor M is driven to slowly rotate the rotating table 2. Moreover, the suction means 12 is activated to vacuum the interior of the housing 1, and air is suctioned from the opening 1a, thereby forming airflow to the outlet 1c.

The suction means 12 is activated after the rotating table 3 is rotated, but the sequence of the operation of the suction means and the rotating table is not limited to the above-explained one.

As explained above, when the rotating table 2 is slowly rotated, the liquid delivery means 10 is controlled to supply the SPM from the process liquid pipe 8.

Moreover, since the tip of the process liquid pipe 8 faces the center of the substrate 3 clamped by the clampers 4, the SPM released from the process liquid pipe 8 is supplied to the center of the processing surface 3a. The SPM supplied to the center of the processing surface 3a as explained above spreads in the circumferential direction by the rotation of the substrate 3 and flows to the outer periphery thereof.

Next, the infrared lamp 13 is moved to the upper space of the opening 1a, and is powered on to heat the substrate 3 until it becomes a temperature of substantially 130 °C to 300 °C.

According to the first embodiment, the infrared lamp 13 that is the heating means is disposed at the rear face side of the substrate 3, and thus the infrared lamp 3 can be moved closer to the substrate 3 regardless of the supply means of the process liquid disposed at the processing-surface-3a side, and can efficiently heat the substrate 3 without being affected by the supplied SPM.

As explained above, when the substrate 3 is heated to a temperature of substantially 130 °C to 300 °C by the infrared lamp 13, the SPM having contacted the processing surface 3a is heated by the heat from the substrate 3, and the chemical reaction is accelerated on the processing surface 3a, thereby accelerating the eliminating process of the resists.

Moreover, according to this device, as explained above, the opening 1a of the housing 1 is slightly larger than the diameter of the substrate 3, the substrate 3 set near the opening 1a just forms an annular and tiny space between the outer periphery of the substrate and the portion of the opening 1a facing with each other, and thus the substrate serves as a cover that substantially blocks off the opening 1a.

With the substrate 3 being serving as the cover that blocks off the opening 1a as explained above, the SPM that is the process liquid is supplied to the processing surface 3a directed to the bottom of the housing. Accordingly, the SPM supplied to the processing surface 3a does not spill out to the exterior of the housing 1 from the opening 1a.

Moreover, the SPM contacting the processing surface of the substrate 3 heated to a high temperature produces vapors, but these vapors are guided to the outlet 1c by the airflow taken in from the opening 1a and evacuated, and thus no vapors leak.

As explained above, since no SPM and vapors leak to the exterior of the housing, wirings and the other devices located outside the housing 1 are not damaged.

Since the substrate 3 serves as the cover that prevents the SPM and the vapors thereof from leaking to the exterior from the housing 1, it is unnecessary to cause the substrate 3 to cover a ceiling of the housing and to provide a separate cover.

As explained above, since it is unnecessary to cover the substrate 3 by a ceiling of the housing and to provide a separate cover, cleaning and drying are simplified. For example, when the substrate 3 is covered by a ceiling or is covered by a cover, it becomes necessary to clean and dry such ceiling and cover, but according to this embodiment, such cleaning and drying are unnecessary.

Moreover, according to the processing device of the first embodiment, since no vapors are evacuated from the opening 1a, the infrared lamp 13 are not contaminated by such vapors, etc. Therefore, the energy of the infrared rays can be utilized to the heating of the substrate 3 without any loss.

Furthermore, according to the processing device of the first embodiment, the substrate 3 is heated by the infrared lamp 13, and the resist eliminating process becomes efficient. For example, in order to enhance the reactivity of the SPM with the resists on the substrate, according to the conventional technology, the SPM heated to a high temperature in advance is supplied, but in this case, the SPM contacts the substrate that has a low temperature, and the temperature of the SPM decreases, and thus the reaction of the SPM with the resists becomes insufficient in some cases. If the heat of the SPM is absorbed by the substrate, it is necessary to supply a large amount of the SPM at the high temperature in order to prevent such temperature falling. However, when the substrate 3 is heated like the first embodiment, the temperature falling of the SPM can be prevented, and thus it becomes unnecessary to supply a large amount of the SPM, and the SPM can be saved by what corresponds to such unnecessity.

The processing device of the first embodiment has a function of rotating the substrate 3 by rotating the rotating table 2, when the SPM is supplied to the center of the processing surface 3a while rotating the substrate 3, the supplied SPM can be applied uniformly toward the outer periphery on the processing surface 3a. In particular, according to the first embodiment, the substrate 3 is held in such a way that the processing surface 3a is directed toward the bottom of the housing 1, the SPM supplied to the processing surface 3a is likely to fall, but the substrate 3 is rotated as explained above, and thus the SPM is prevented from falling due to the centrifugal force of the rotation and is applied uniformly toward the outer periphery of the substrate 3. Therefore, the eliminating process of the resists becomes uniform.

Moreover, since the SPM can be applied uniformly toward the outer periphery by rotating the substrate 3, it does not necessary for the supply means to have a dispersing function, and the structure of the supply means can be simplified.

In other words, when the supply means has a mechanism that supplies the process liquid uniformly to the whole processing surface, the function of rotating the substrate 3 in the processing step is unnecessary. Moreover, the substrate 3 may be rotated, while at the same time, the dispersing function of the process liquid is provided.

Furthermore, by rotating the substrate 3 together with the rotating table 2, even if the irradiation range of the infrared rays by the infrared lamp 13 does not match the whole surface of the substrate 3, there is an advantage that the substrate 3 can be heated uniformly. When, for example, the irradiation range of the infrared rays is linear along the diameter or the radius of the substrate 3, the infrared rays can be emitted to the whole rear face of the substrate 3 by rotating the substrate 3.

According to the processing device of the first embodiment, since the supply means of the pure water is provided, after the resist eliminating process is executing using the SPM, the processing surface 3a can be cleaned by water. Accordingly, an explanation will now be given of the cleaning process.

In the cleaning process, the infrared lamp 13 is powered off, and the infrared lamp 13 is retracted from the range corresponding to the opening 1a, and the supply of the SPM is terminated.

Next, the cleaning port of the water pipe 16 is moved to the upper space of the opening 1a of the housing 1, and with the rotating table 2 being rotated, the pure water is supplied on the substrate 3 from the water pipe 16 by unillustrated water delivery means, thereby cleaning the rear face of the substrate 3.

Moreover, at the processing-surface-3a side, the pure water is supplied from the water pipe 9 by the water delivery means 11, thereby cleaning the processing surface 3a of the substrate 3.

At this time, since the rotating table 2 is rotated, the pure water supplied to both surfaces of the substrate 3 spreads toward the outer periphery thereof, and cleans both surfaces of the substrate 3.

In the housing 1, the pure water directed to the circumferential direction along the rotating substrate 3 collides the internal wall of the housing 1, thereby cleaning the internal wall.

In particular, according to the first embodiment, the process liquid is supplied from the same direction as the supply direction of the process liquid to clean the substrate, and thus the way of spreading and spilling the cleaning liquid becomes consistent with those of the process liquid. Accordingly, the internal wall of the housing 1 where the process liquid adheres can be cleaned simultaneously with the substrate.

After both surfaces of the substrate 3 are cleaned by pure water, the water supply is terminated, and the rotating speed of the motor M is increased. Next, the rotating table 2 is rotated at 1000 (rpm) to 3000 (rpm) or so, and the moisture is completely repelled by the centrifugal force, thereby letting both surfaces of the substrate 3 dried. As explained above, the moisture can be repelled by the centrifugal force, the substrate 3 can be let dried within a short time without leaving a water mark on the substrate after cleaning.

When the rotating speed of the rotating table 2 is increased with the space between the rotating table 2 and the processing surface 3a of the substrate 3 being narrowed, the interior of such a space is likely to be a negative pressure condition. When such a space is left as it is after the interior of the space becomes a negative pressure condition, foreign materials in the housing may be suctioned into the space between the rotating table and the processing surface facing with each other, and may adhere to the processing surface 3a.

In order to suppress this phenomenon, according to this embodiment, when the rotating speed is increased, a nitrogen gas is supplied to the interior of such a space, thereby preventing a negative pressure condition.

According to the first embodiment, the opening 1a of the present invention for letting in the substrate 3 in the housing serves as both inlet of air and inlet of the infrared rays, but respective openings may be separately provided. However, when a structure having an opening serving as all of the three openings is employed, there is an advantage that the structure of the housing 1 can be simplified.

According to the first embodiment, the infrared lamp 13 and the water pipe 16 are retractable from the region corresponding to the opening 1a, but the infrared lamp 13 and the water pipe 16 may be fastened near the opening 1a as far as those does not disturb steps like putting in and out of the substrate 3 relative to the interior of the housing 1.

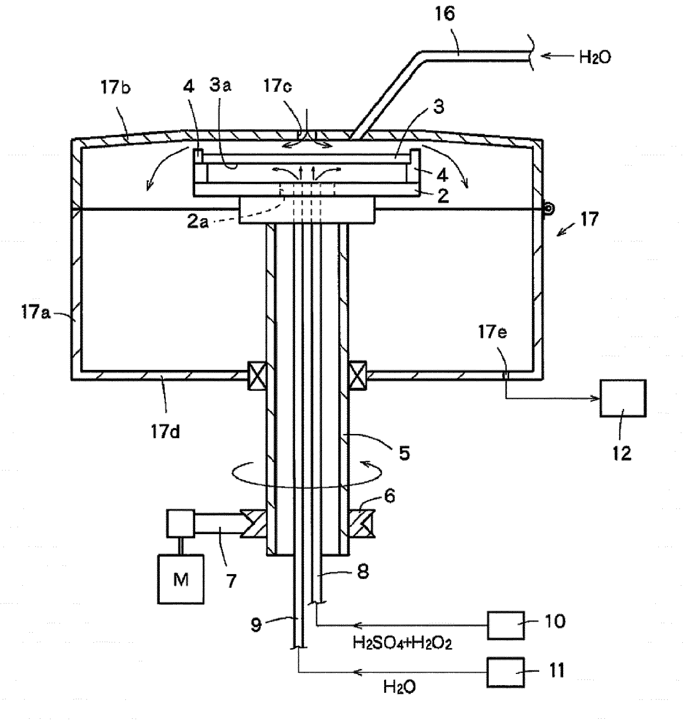

FIG. 2 is a diagram showing a structure of a second substrate processing device.

This substrate processing device is also a single-wafer processing device for eliminating resists from a semiconductor substrate. The same structural element as that of the first embodiment will be denoted by the same reference numeral as that of FIG. 1, and the same structure as that of the first embodiment is as follows.

In the second device, also, the rotating table 2 is provided inside a housing 17, and the rotating table 2 has the clampers 4. The clampers 4 hold the substrate 3 with the processing surface 3a thereof being directed to a bottom 17d of the housing 17.

The supply means of the process liquid includes the process liquid pipe 8 and the liquid delivery means 10, and the clearing liquid supply means includes the water pipe 9 and the water delivery means 11.

Those structures are consistent with those of the first embodiment.

According to the second device employing the above-explained same structure as that of the first embodiment, the structure of the housing 17 is remarkably different from that of the first embodiment. That is, the housing 17 has a lid 17b openable/closable to a main body 17a, and the substrate 3 is put in and out by opening the lid 17b.

When the substrate 3 is set on the rotating table 2 and the lid 17b is closed, the internal side of the lid 17b that is a ceiling of the housing 17 faces the rear face of the substrate 3.

Accordingly, when the process liquid is supplied to the processing surface 3a 0659-71521EP/TH of the substrate 3, the substrate 3 provides a shielding function against the process liquid, and thus no process liquid adhere to the ceiling.

Moreover, an inlet 17c for introducing air is formed in the center of the lid 17b, and an outlet 17e for evacuating the air is formed in the bottom 17d of the main body 17a. The outlet 17e is connected with the suction means 12.

Hence, when the suction means 12 vacuums the interior of the housing 17, airflow from the inlet 17c to the outlet 17e is produced.

According to the second device, no infrared lamp 13 that is the heating means is provided above the housing 17 unlike the first embodiment. Hence, unillustrated heating means for heating in advance the SPM during the supply thereof is additionally provided.

Moreover, the water pipe 16 for supplying pure water to the substrate 3 is fixed to the lid 17b, and the water pipe 16 is connected with unillustrated water delivery means. Hence, with the lid 17b being closed, when the pure water is supplied from the water pipe 16, the rear face of the substrate 3 held on the rotating table 2 can be cleaned.

Next, an explanation will be given of processes of eliminating resists from the processing surface 3a of the substrate 3 by the second device.

First, the lid 17b of the housing 17 is opened, and the substrate 3 is set on the rotating table 2 with the processing surface 3a being directed to the rotating table 2.

When the substrate 3 is set, the lid 17b is closed, and the motor M is driven to slowly rotate the rotating table 2. At this time, the suction means 12 is activated to vacuum the interior of the housing 17, thereby producing airflow from the opening 17c to the outlet 17e.

As explained above, when the rotating table 2 is slowly rotated, the water delivery means 10 is controlled to supply the SPM heated in advance from the process liquid pipe 8.

Moreover, like the first embodiment, the tip of the process liquid pipe 8 is caused to face the center of the substrate 3 clamped by the clampers 4. Accordingly, the SPM released from the process liquid pipe 8 is supplied to the center of the processing surface 3a. The SPM supplied to the center of the processing surface 3a as explained above flows toward the outer periphery of the substrate 3 while spreading in the circumferential direction by the rotation of the substrate, and the resists are eliminated during the flow of the SPM.

When the process by the SPM completes through the above-explained procedures, the water delivery means 10 is deactivated, and the water supply means 11 and the unillustrated water delivery means are controlled to supply pure water from the water pipes 9 and 16, thereby cleaning both surfaces of the substrate 3 simultaneously.

At this time, since the rotating table 2 is being rotated, the pure water supplied to both surfaces of the substrate 3 spreads toward the outer periphery of the substrate, and cleans both surfaces of the substrate 3.

Moreover, in the housing 17, the pure water supplied from the water pipe 9 is directed to the circumferential direction by the rotation of the substrate 3, and this pure water collides the internal wall of the housing 17. Accordingly, the internal wall of the housing 17 can be cleaned together with the cleaning of the substrate 3.

Thereafter, the water delivery is terminated, and like the first embodiment, the rotating speed of the motor M is increased to completely repel the moisture by the centrifugal force, the substrate 3 can be let dried within a short time without leaving a water mark.

When the rotating speed of the rotating table 2 is increased with the space between the rotating table 2 and the processing surface 3a of the substrate 3 being narrowed, the interior of such a space is likely to be a negative pressure condition. When such a space is left as it is after the interior of the space becomes a negative pressure condition, foreign materials in the housing may be suctioned into the space between the rotating table and the processing surface facing with each other, and may adhere to the processing surface 3a.

In order to suppress this phenomenon, according to this device, when the rotating speed is increased, a nitrogen gas is supplied to the interior of such a space, thereby preventing a negative pressure condition.

According to the second device, also, the rear face of the substrate 3 faces the ceiling of the housing 17, and the processing surface 3a is directed to the bottom 17d. Hence, the SPM supplied to the processing surface 3a does not directly adhere to the ceiling of the housing 17.

Moreover, by the airflow taken in through the inlet 17c formed in the lid 17b, the vapors of the SPM are guided to the outlet 17e formed in the bottom 17d of the housing 17, and thus no vapors adhere to the ceiling inside the housing 17.

Accordingly, it is unnecessary to open the lid 17b of the housing 17 and to clean the SPM adhered to the ceiling, making the process of the substrate 3 efficient.

Moreover, when the substrate 3 is cleaned, the SPM adhering to the interior of the housing 17 can be also cleaned.

According to the second device, no heating means for heating the substrate 3 is provided, but an infrared lamp, etc., as the heating means may be provided above the housing 17. In this case, it is necessary to form an infrared ray inlet for allowing infrared rays to pass through at an area of the lid 17b corresponding to the substrate 3. The infrared ray inlet may be an opening or may be covered by a glass that allows the infrared rays to pass through.

In any cases, the SPM supplied from the process liquid pipe 8 to the processing surface 3a is blocked by the substrate 3, and the vapors thereof are evacuated from the outlet 17e at the bottom, and thus no SPM and vapors thereof go out from the infrared ray inlet formed in the lid 17b and the glass does not mist over. That is, the rear face of the substrate 3 can be surely heated through the infrared ray inlet.

Moreover, according to the second device, a structure is employed in which the substrate 3 is put in and out by opening/closing the lid 17b, the ceiling of the housing 17 may be completely blocked off, and the substrate 3 may be put in and out through a side face of the housing 17. In this case, the relationship between the gaseous body inlet and the outlet remains same as that of the second device. That is, airflow from the inlet 17c of the gaseous body provided above the processing surface 3a of the substrate 3 to the outlet 17e provided downwardly of the processing surface 3a is produced to evacuate the vapors of the process liquid.

When the ceiling of the housing is completely blocked off as explained above, no process liquid and vapors thereof adhere to the ceiling, and thus it is unnecessary to clean the ceiling. Therefore, there is no problem even if the ceiling is completely blocked off.

According to the first embodiment and the second device, the air inlets 1a, 17c are formed in the ceiling of the housings 1, 17, and the outlets 1c, 17e are formed in the bottoms 1b, 17d of the housings 1, 17, but respective positions thereof are not limited to the positions in the above-explained examples .

As far as the relationship that the inlets 1a, 17c are provided at the same level as that of the processing surface 3a of the substrate 3 or thereabove and the outlets 1c, 17e are provided downwardly of the inlets 1a, 17c, like the above-explained examples , the vapors attempting to go up from the outer periphery of the processing surface 3a can be surely held to the lower space by the airflow from the upper space, and thus no vapors leak out to the exteriors of the housings 1, 17.

Moreover, the condition in which the inlet is located at the same level as that of the processing surface means that the level of the processing surface is located within the range of the aperture of the inlets 1a, 17c.

However, as far as the airflow can be produced in the housing, respective positions of the inlet and the outlet are not limited to those of the first embodiment and the second device, and the up-and-down relationship of the inlet and the outlet is not limited to those of the first embodiment and the second device.

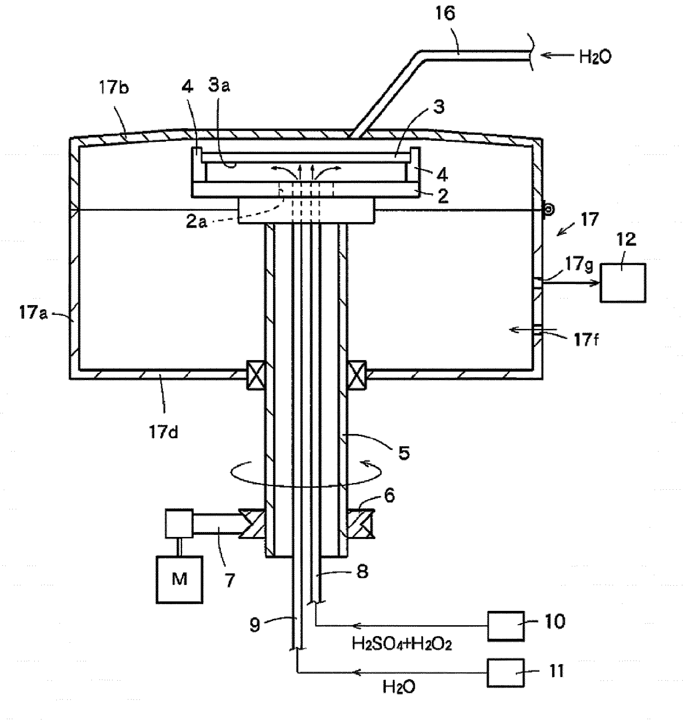

FIG. 3 shows a structure of a third substrate processing device having an air inlet 17f provided downwardly of an outlet 17g.

The substrate processing device of the third example is also a single-wafer processing device for eliminating resists from a semiconductor substrate, and respective positions of the gaseous body inlet and the outlet are different from those of the second device, but the other structures are the same as those of the second device.

Accordingly, the same structural element as that of the second device will be denoted by the same reference numeral in FIG. 2, and the detailed explanation thereof will be omitted.

The substrate processing device of the third example has, like the second device, the housing 17 including the main body 17a and the openable/closable lid 17b, and the substrate 3 is put in and out by opening the lid 17b.

According to the third device, however, no opening is formed in the lid 17b, and the gaseous body inlet 17f and the outlet 17g are provided at a side face of the main body 17a. Moreover, the inlet 17f is provided below the processing surface 3a of the substrate, and the outlet 17g is provided above the inlet 17f. Furthermore, the outlet 17g is connected with the suction means 12, and the suction means 12 vacuums the interior of the housing 17, thereby producing airflow to the outlet 17g in the housing 17.

Like the second device, the substrate processing device of the third 25 example can eliminate resists from the processing surface 3a of the substrate 3. That is, in the housing 17, with the processing surface 3a being caused to face the rotating table 2, the substrate 3 is set on the rotating table 2, and the process liquid is supplied to the processing surface 3a from the bottom-17d side, thereby eliminating the resists.

When the resists are eliminated as explained above, the suction means 12 is activated to vacuum the interior of the housing 17.

Hence, according to the third device, the vapors of the SPM that is the process liquid are evacuated from the outlet 17g, and do not leak out to the exterior from the housing 17.

According to the third device, the air inlet 17f is provided below the processing surface 3a of the substrate 3 and below the outlet 17g. Hence, if airflow that causes air taken in from the inlet 17f to directly flow to the outlet 17g is produced, it is difficult to efficiently evacuate the vapors. In practice, however, the suction means 12 does not directly suction the air from the inlet 17f, but suctions the gaseous body in the whole interior of the housing 17. In particular, when the rotating table 2 is rotated and the process liquid is supplied, the airflow in the housing 17 becomes turbulent, and thus it is substantially impossible to produce only airflow from the inlet 17f to the outlet 17g. Hence, according to the substrate processing device of the third example, it is possible to evacuate the vapors of the process liquid in the housing 17 from the outlet 17g.

However, when the inlet is provided near the processing surface, and the outlet is provided below the inlet, airflow of forcibly guiding the vapors of the process liquid to the outlet can be further easily produced.

Moreover, when the substrate 3 is set on the rotating table 2 and the lid 17b is closed, the internal side of the lid 17b that is the ceiling of the housing 17 faces the rear face of the substrate 3.

Hence, when the process liquid is supplied to the processing surface 3a of the substrate 3, the substrate 3 has the shielding function against the process liquid, and thus no process liquid adhere to the ceiling. Accordingly, the process liquid does not spill out from the upper part of the housing 17, and a step of cleaning the SPM adhered to the ceiling by opening the lid 17b of the housing 17 is unnecessary, thereby making the process of the substrate 3 efficient.

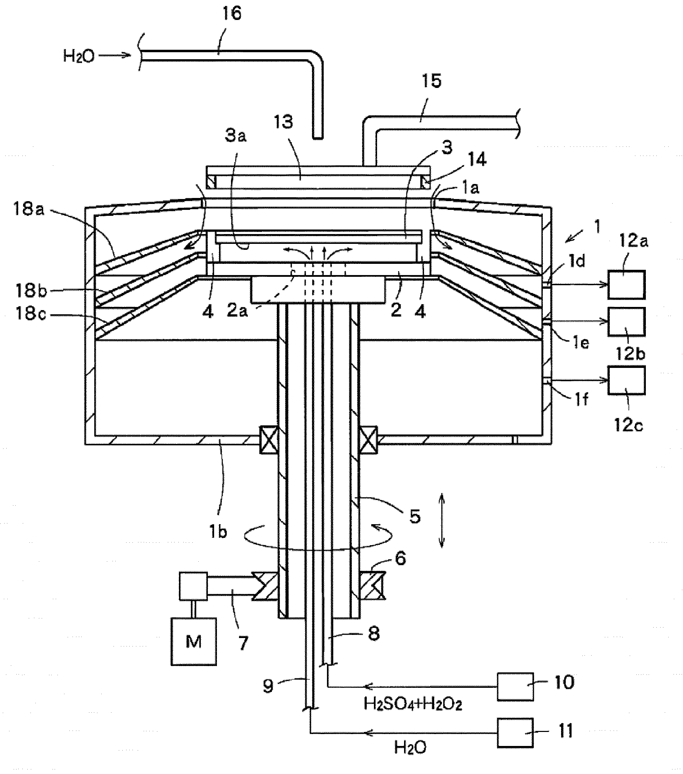

FIG. 4 shows a fourth embodiment in which three outlets 1d, 1e, and 1f for evacuating the gaseous body together with the vapors of the process liquid are provided in the housing 1, and guide members 18a, 18b, and 18c for guiding such gaseous body to respective outlets Id, 1e, and 1f are provided.

Moreover, according to the fourth embodiment, the upper and lower positions of the rotating table 2 that holds the substrate 3 are changeable. More specifically, unillustrated driving means ascends/descends the rotating table 2 while maintaining coupling of the cylinder member 5, the process liquid pipe 8 and the water pipe 9 fixed to the rotating table with associated members.

The other structures are the same as those of the first embodiment shown in FIG. 1, and the same structural element as that of the first embodiment will be denoted by the same reference numeral in FIG. 1, and the detailed explanation thereof will be omitted.

The guide members 18a, 18b, and 18c are each a conic member having an opening at the center thereof, and are provided at the internal wall of the housing 1 while maintaining a predetermined clearance with respect to each other in the axial direction of the cylinder member 5.

The outlet Id, the outlet 1e, and the outlet 1f are provided between the upper guide member 18a and the middle guide member 18b, between the middle guide member 18b and the lower guide member 18c, and below the lower guide member 18c at the basal end sides of respective guide members 18a, 18b, and 18c.

Moreover, respective outlets are connected with suction means 12a, 12b, and 12c to evacuate the gaseous body containing the vapors of the process liquid in the housing 1.

That is, the guide members 18a and 18b are guide members guiding the vapors of the process liquid to the outlet Id, the guide members 18b and 18c are guide members guiding the vapors to the outlet 1e, and the guide member 18c is a guide member guiding the vapors to the outlet 1f.

For example, when the periphery of the substrate 3 is adjusted so as to face a tip of the upper guide member 18a that is a part thereof, and the suction means 12a is activated to start the process, the vapors of the process liquid supplied to the processing surface 3a are guided to the outlet 1d by the guide members 18a and 18b.

Moreover, when the periphery of the substrate 3 is adjusted so as to face a tip of the middle guide member 18b, and the suction means 12b is activated, the vapors of the process liquid are guided to the outlet 1e, and when the periphery of the substrate 3 is adjusted so as to face a tip of the lower guide member 18c and the suction means 12c is activated, the vapors of the process liquid are guided to the outlet 1f.

As explained above, depending on the position of the substrate 3, the outlet where the vapors are guided can be changed. Hence, when the position of the substrate 3 is changed depending on the kind of the process liquid, and the outlets are separately used, the process liquids can be separately collected kind by kind at the ends of the suction means 12a, 12b, and 12c, and thus there is an advantage that a disposal process and recycling can be carried out smoothly.

The expression that the periphery of the substrate 3 is caused to face the tip of the guide member means adjusting the height of the substrate 3 and causing the periphery of the substrate 3 to come close to the tip of the guide member, and it is unnecessary that the height position of the substrate 3 and the position of the tip of the guide member are strictly leveled, and either one of the substrate 3 and the guide member may be slightly located up and down relative to each other. However, if the processing surface 3a of the substrate 3 is located below the tip of the guide member that guides the gaseous body, vapors of the process liquid, etc., can be surely evacuated. Moreover, when the rear face of the substrate 3 is located at the same height position of the tip of the guide member or below the tip of the guide member, if the cleaning liquid, etc., is supplied from the rear face side, the cleaning liquid, etc., can also be drained from the outlet.

The substrate processing device of the fourth embodiment can eliminate resists from the processing surface 3a of the substrate 3 like the first embodiment.

That is, in the housing 1, with the processing surface 3a being caused to face the rotating table 2, the substrate 3 is set on the rotating table 2, and the process liquid is supplied to the processing surface 3a from the bottom-lb side, thereby eliminating the resists.

However, according to the fourth embodiment, the process is started after the periphery of the substrate 3 is caused to face the tip of any one of the guide members. Moreover, the suction means corresponding to that guide member is activated.

For example, as shown in FIG. 4, when the periphery of the substrate 3 is caused to face the tip position of the upper guide member 18a, only the suction means 12a is activated. Next, when the process of the substrate 3 starts, air suctioned through the opening 1a formed in the ceiling of the housing 1 is guided to the outlet 1d by the guide member 18a, and thus airflow for draining the processing liquid is produced.

Hence, according to the fourth embodiment, the vapors of the SPM that is the process liquid are evacuated from the outlet Id, and do not leak out to the exterior from the housing 1.

Moreover, when the process liquid other than the SPM is used, the periphery of the substrate 3 is set to face the tip of another guide member, e.g., the guide member 18b, and the suction means 12b is activated. According to this setting, the vapors of the process liquid are guided to the outlet 1e by the guide member 18b together with air taken in from the opening 1a. In this case, also, the vapors of the process liquid are evacuated from the outlet 1e, and do not leak out to the exterior from the housing 1.

According to the fourth embodiment, the three guide members 18a, 18b, and 18c and the outlets 1d, 1e, and 1f are provided, but the number of the guide members and that of the outlets can be any number. When it is desirable to separately drain the process liquid for each kind, the outlets depending on the kinds of the process liquids and the guide members for guiding the gaseous body to respective outlets are necessary.

Moreover, when it is unnecessary to separate the process liquids depending on the kind thereof, if the guide member is provided, air taken in from the inlet can be guided to the outlet, and airflow efficiently evacuating the vapors of the process liquid can be produced.

According to the fourth embodiment, respective tips of the guide members 18a, 18b, and 18c correspond to "a part of a guide member facing a periphery of a substrate held by the holding means" of the present invention, but the above-explained part is a portion facing the periphery of the substrate and is not limited to the tip depending on the shape of the guide member.

According to the first to fourth embodiments, air is taken in from the inlet, but the kind of the gaseous body taken in to the interior of the housing is not limited to any particular one as far as it does not affect the process liquid and the substrate.

Moreover, means for taking in a gaseous body to the interior of the housing through the inlet may be one which applies pressure from the inlet and which pushes a gaseous body into the interior of the housing in addition to the suction means connected with the outlet.

Furthermore, when a plurality of outlets are not provided unlike the fourth embodiment, a gaseous body taken in from the inlet is efficiently evacuated from the outlet together with the vapors of the process liquid in the housing, and it is appropriate to form the guide member in the housing.

According to the first to fourth embodiments, the substrate 3 is held horizontally in the housings 1 and 17, but it is fine if the substrate 3 is not horizontal as far as the processing surface 3a is directed to the bottom of the housing.

In the above-explained embodiments, the explanation was given of the example device that executes a process of eliminating resists formed on the processing surface 3a, but the substrate processing device of the present invention is useful as a device that executes a process of eliminating thin films other than resists, and other adhering materials. However, it is necessary to select a process liquid depending on the substance subjected to the eliminating process. For example, in order to execute the eliminating process of nitride films, phosphoric acid is used, and HPM (hydrochloric hydrogen peroxide solution)or APM (ammonium hydrogen peroxide solution), etc., are used to process various thin films and adhering materials like particles on the processing surface 3a like the eliminating process of the resists.

In order to provide plural kinds of process liquids, when process liquid pipes for respective process liquids are provided in the cylinder member 5, the plural kinds of processes can be performed by the same device.

In any cases, a cleaning process of additionally cleaning a ceiling of the housing or a cover where vapors of the process liquid adhere becomes unnecessary.

Furthermore, according to the above-explained embodiments, the infrared lamp is used as the means for heating the substrate, but the heating means is not limited to the infrared lamp as far as it can heat the substrate in a non-contact manner so that no process liquid adheres to such means. For example, microwave irradiation is possible as the heating means. However, microwave irradiation increases the costs of facility, and the heating means utilizing infrared rays is advantageous from the standpoint of costs. Moreover, when infrared rays are utilized, the present invention is not limited to the infrared lamp and an infrared heater can be used.

### Industrial Applicability

The present invention is useful for an eliminating process of thin films on a liquid crystal glass substrate, and a plasma display substrate, etc., in addition to a semiconductor substrate.

### Reference Signs List

- 1: Housing
- 1a: Opening
- 1b: Bottom
- 1c: Outlet
- 1d: Outlet
- le: Outlet
- 1f: Outlet
- 2: Rotating table
- 3: Substrate
- 3a: Processing surface
- 4: Clamper
- 8: Process liquid pipe
- 9: Water pipe
- 10: Liquid delivery means
- 11: Water delivery means
- 12: Suction means
- 12a: Suction means
- 12b: Suction means
- 12c: Suction means
- 13: Infrared lamp
- 17: Housing
- 17c: Inlet
- 17d: Bottom
- 17e: Outlet
- 18a: Guide member
- 18b: Guide member
- 18c: Guide member

## Claims

1. A substrate processing device comprising:
a housing (1, 17), the housing (1) has a top face with an inlet/outlet opening (1a) for letting a substrate (3) in and out to the housing (1), the inlet/outlet opening (1a) having a diameter slightly larger than the diameter of the substrate (3);
holding means (4) that holds, in the housing (1, 17), a substrate (3) subjected to an eliminating process of adhering materials on a processing surface (3a) of the substrate (3) with the processing surface (3a) being directed to a bottom of the housing (1);
a rotating table (2) that includes, on a surface thereof, the holding means (4);
supply means (8, 9) for supplying a process liquid to the processing surface (3a) of the substrate (3) held by the holding means (4) from the bottom side thereof;
an inlet for taking a gaseous body in the housing (1), the inlet being a clearance formed between an outer periphery of the substrate (3) and the inlet/outlet opening (1a) of the housing (1); and
an outlet (1c) for evacuating, from the housing (1), vapors of the process liquid in the housing (1) together with the gaseous body taken in from the inlet **characterized by** further comprising:
a suction means (12) connected with the outlet (1c), the suction means (12) designed to vacuum an interior of the housing (1) to suction air from the inlet to produce airflow; and
an infrared lamp (13) provided above the inlet/outlet opening (1a) for heating a rear side of the substrate (3).

2. The substrate processing device according to claim 1,
wherein a resist or nitride film is formed on the processing surface (3a);
the resist or the nitride film formed on the processing surface (3a) is eliminated by the process liquid supplied to the processing surface (3a), and
the airflow is directed to the outlet from the inlet, thereby evacuating vapors of the processing liquid from the housing (1).

3. The substrate processing device according to claim 1 or 2, wherein the inlet (1ac) is provided above the processing surface (3a).

4. A method of processing a substrate (3) comprising the steps of
- providing a substrate processing device according to any one of claims 1 to 3
- letting a substrate (3) into the housing (1) of the substrate processing device by its inlet/outlet opening (1a), the substrate (3) is set on the rotating table (2) with the processing surface (3a) being caused to face the rotating table (2);
- activating the suction means (12) to vacuum an interior of the housing (1), air is suctioned from the inlet/outlet opening (1a), thereby forming airflow to the outlet (1c);
- supplying a process liquid to a bottom side of said substrate (3) as a processing surface (3a);
- heating a rear side of the substrate (3) using the infrared lamp (13);
- removing the substrate (3) from the housing (1) by the inlet/outlet opening (1a).

## Patentansprüche

1. Vorrichtung zur Bearbeitung eines Substrats mit:
einem Gehäuse (1, 17), wobei das Gehäuse (1) eine Oberseite mit einer Einlass-/Auslassöffnung (1a) aufweist, um ein Substrat (3) in das Gehäuse (1) hinein- und herauszulassen, wobei die Einlass-/Auslassöffnung (1a) einen Durchmesser aufweist, der etwas größer als der Durchmesser des Substrats (3) ist;
einer Halteeinrichtung (4), die in dem Gehäuse (1, 17) ein Substrat (3) hält, das einer Bearbeitung zum Entfernen von an einer Bearbeitungsoberfläche (3a) des Substrats (3) anhaftenden Materialien unterzogen wird, wobei die Bearbeitungsoberfläche (3a) einem Boden des Gehäuses (1) zugekehrt ist;
einem Drehtisch (2), der an einer Oberfläche die Halteeinrichtung (4) aufweist;
Zuführmitteln (8, 9) zum Zuführen einer Bearbeitungsflüssigkeit zu der Bearbeitungsoberfläche (3a) des von der Halteeinrichtung (4) gehaltenen Substrats (3) von dessen Unterseite her;
einem Einlass zur Aufnahme eines gasförmigen Körpers in das Gehäuse (1), wobei der Einlass ein zwischen einem Außenumfang des Substrats (3) und der Einlass-/Auslassöffnung (1a) des Gehäuses (1) gebildeter Zwischenraum ist; und
einem Auslass (1c) zum Evakuieren von Dämpfen der Bearbeitungsflüssigkeit im Gehäuse (1) zusammen mit dem vom Einlass her angesaugten gasförmigen Körper aus dem Gehäuse (1),
**dadurch gekennzeichnet, dass** sie ferner umfasst:
eine Absaugeinrichtung (12), die mit dem Auslass (1c) verbunden ist, wobei die Absaugeinrichtung (12) ausgelegt ist, einen Innenraum des Gehäuses (1) abzusaugen, um Luft aus dem Einlass anzusaugen und einen Luftstrom zu erzeugen; und
eine Infrarotlampe (13), die über der Einlass-/Auslassöffnung (1a) zum Erwärmen einer Rückseite des Substrats (3) vorgesehen ist.

2. Substratbearbeitungsvorrichtung nach Anspruch 1,
wobei ein Resist- oder Nitridfilm auf der Bearbeitungsoberfläche (3a) gebildet ist;
der auf der Bearbeitungsoberfläche (3a) gebildete Resist- oder Nitridfilm durch die der Bearbeitungsoberfläche (3a) zugeführte Bearbeitungsflüssigkeit entfernt wird, und
der Luftstrom vom Einlass zum Auslass geleitet wird, wodurch Dämpfe der Bearbeitungsflüssigkeit aus dem Gehäuse (1) abgesaugt werden.

3. Substratbearbeitungsvorrichtung nach Anspruch 1 oder 2, bei der der Einlass (1a) oberhalb der Bearbeitungsfläche (3a) vorgesehen ist.

4. Verfahren zur Bearbeitung eines Substrats (3), das die folgenden Schritte umfasst:
- Bereitstellen einer Substratbearbeitungsvorrichtung nach einem der Ansprüche 1 bis 3;
- Einlassen eines Substrats (3) in das Gehäuse (1) der Substratbearbeitungsvorrichtung durch seine Einlass-/Auslassöffnung (1a), wobei das Substrat (3) so auf den Drehtisch (2) gesetzt wird, dass die Bearbeitungsfläche (3a) dem Drehtisch (2) zugewandt ist;
- Aktivieren der Absaugeinrichtung (12), um das Innere des Gehäuses (1) abzusaugen, wobei Luft aus der Einlass-/Auslassöffnung (1a) abgesaugt wird, wodurch ein Luftstrom zum Auslass (1c) entsteht;
- Zuführen einer Bearbeitungsflüssigkeit zu einer Unterseite des Substrats (3) als Bearbeitungsoberfläche (3a);
- Erwärmen einer Rückseite des Substrats (3) unter Verwendung der Infrarotlampe (13);
- Entfernen des Substrats (3) aus dem Gehäuse (1) durch die Einlass- / Auslassöffnung (1a).

## Revendications

1. Dispositif de traitement de substrat comprenant :
un boîtier (1, 17), le boîtier (1) ayant une face supérieure avec une ouverture d'entrée/sortie (1a) pour laisser un substrat (3) entrer et sortir du boîtier (1), l'ouverture d'entrée/sortie (1a) ayant un diamètre légèrement supérieur au diamètre du substrat (3) ;
un organe de maintien (4) qui maintient, dans le boîtier (1, 17), un substrat (3) soumis à un processus d'élimination de matière adhérente à une surface de traitement (3a) du substrat (3), la surface de traitement (3a) étant dirigée vers un fond du boîtier (1) ;
une table tournante (2) qui comprend, sur une surface de celle-ci, l'organe de maintien (4) ;
des moyens d'alimentation (8, 9) pour alimenter en liquide de traitement la surface de traitement (3a) du substrat (3) maintenu par l'organe de maintien (4) depuis le côté inférieur de celui-ci ;
une entrée pour recevoir un corps gazeux dans le boîtier (1), l'entrée étant un espace formé entre une périphérie extérieure du substrat (3) et l'ouverture d'entrée/sortie (1a) du boîtier (1) ; et
une sortie (1c) pour évacuer du boîtier (1) les vapeurs du liquide de traitement dans le boîtier (1) conjointement avec le corps gazeux reçu à l'entrée,
**caractérisé en ce qu'**il comprend en outre :
un organe d'aspiration (12) relié à la sortie (1c), l'organe d'aspiration (12) étant conçu pour faire le vide à l'intérieur du boîtier (1) afin d'aspirer l'air provenant de l'entrée pour produire un écoulement d'air ; et
une lampe infrarouge (13) prévue au-dessus de l'ouverture d'entrée/sortie (1a) pour chauffer une face arrière du substrat (3).

2. Dispositif de traitement de substrat selon la revendication 1,
dans lequel un film de résine sensitive ou de nitrure est formé sur la surface de traitement (3a) ;
le film de résine sensitive ou de nitrure formé sur la surface de traitement (3a) est éliminé par le liquide de traitement fourni à la surface de traitement (3a), et
l'écoulement d'air est dirigé vers la sortie depuis l'entrée, évacuant ainsi les vapeurs du liquide de traitement du boîtier (1).

3. Dispositif de traitement de substrat selon la revendication 1 ou 2, dans lequel l'entrée (1a) est prévue au-dessus de la surface de traitement (3a).

4. Méthode de traitement d'un substrat (3) comprenant les étapes consistant à :
- prévoir un dispositif de traitement de substrat selon l'une quelconque des revendications 1 à 3 ;
- introduire un substrat (3) dans le boîtier (1) du dispositif de traitement de substrat par son ouverture d'entrée/sortie (1a), le substrat (3) étant placé sur la table tournante (2), la surface de traitement (3a) étant amenée à faire face à la table tournante (2) ;
- activer l'organe d'aspiration (12) pour mettre sous vide un intérieur du boîtier (1), l'air étant aspiré par l'ouverture d'entrée/sortie (1a), formant ainsi un écoulement d'air vers la sortie (1c) ;
- alimenter en liquide de traitement un côté inférieur dudit substrat (3) en tant que surface de traitement (3a) ;
- chauffer un côté arrière du substrat (3) en utilisant la lampe infrarouge (13) ;
- retirer le substrat (3) du boîtier (1) par l'ouverture d'entrée / sortie (1a).
